# EUROPEAN PATENT SPECIFICATION

(11) **EP 2 465 972 B1**
(45) Date of publication and mention of the grant of the patent: **03.05.2017**
(21) Application number: 11193595.3
(22) Date of filing: 14.12.2011
(51) Int. Cl.: C23C 16/54, C23C 16/455

(54) **Method and system for thin film deposition**
Verfahren und System zur Dünnfilmablagerung
Procédé et système pour dépôt de film à couche mince

(30) Priority: 15.12.2010 KR 20100128147; 15.12.2010 KR 20100128157; 15.12.2010 KR 20100128158
(43) Date of publication of application: 20.06.2012
(73) Proprietor: NCD Co., Ltd., Daejeon-si 305-509 (KR)
(72) Inventor: Shin, Woong Chul, Daejeon-si 305-755 (KR); Baek, Min, Daejeon-si 305-793 (KR); Choi, Kyu-Jeong, Daejeon-si 305-761 (KR)
(74) Representative: Chaillot, Geneviève

(56) References cited:
- US-A1- 2003 140 854
- US-A1- 2008 026 251
- US-A1- 2009 297 710
- US-A1- 2010 166 955

## Description

### BACKGROUND

### 1. Field of the Invention

Embodiments of the invention relate to a method and system for thin film deposition, and more specifically, to a method and system for thin film deposition, which includes a process chamber configured to provide a laminar gas flow and virtually divided into several spaces when a reaction gas and a purge gas are consecutively supplied into the process chamber, so that atomic layer deposition can be performed with respect to a plurality of substrates while the virtually divided spaces are moved within the process chamber, thereby reducing a process tack time.

### 2. Description of the Related Art

Generally, semiconductor devices or flat display panels are manufactured through various processes. In particular, a process of depositing a thin film on a wafer or glass (hereinafter referred to as a 'substrate') is inevitably carried out. Such thin film deposition is realized by sputtering, chemical vapor deposition (CVD), atomic layer deposition (ALD), and the like.

In particular, atomic layer deposition (ALD) is a process of depositing a thin film in units of an atomic layer through decomposition and adsorption of two or more reactants by sequentially inputting the reactants into a process chamber used for forming a thin film. Specifically, a first reaction gas is supplied in a pulsing manner into the chamber to be chemically deposited to a lower layer of the substrate within the chamber and the remaining first reaction gas physically coupled thereto is removed in a purging manner. Then, a second reaction gas is also supplied and removed through pulsing and purging, such that a desired thin film can be deposited on the substrate through chemical reaction between some of the second reaction gas with the first reaction gas (that is, a first reactant). Examples of thin films produced by atomic layer deposition include Al₂O₃, Ta₂O₃, TiO₂, and Si₃N₄ thin films.

Since atomic layer deposition enables formation of a thin film having good step coverage even at low temperature of 600 °C or less, it is expected that the atomic layer deposition will be widely applied to manufacture of next generation semiconductor devices. In the atomic layer deposition described above, a duration for which the respective gases perform pulsing and purging once is referred to as a cycle.

However, since a conventional apparatus for atomic layer deposition supplies gas in a dot pattern through a spray hole of a diffusing plate instead of a plane pattern, the gas is not uniformly distributed within the process chamber, thereby deteriorating uniformity of the thin film.

For example, US 2009/0297710 A1 discloses an atomic layer deposition apparatus in which gas flow is first conducted vertically in a bottom-to-top direction, horizontally, to then pass through a mesh and enter in the reaction chamber. The gas flows then vertically in a top-to-bottom direction in between the vertically placed substrates. In US 2008/0026251 A1, the gas is fed to the reaction chamber through a plurality of nozzles extending from bottom to top along the inner wall of the reaction chamber and are provided with a great number of holes arranged in the vertical direction and in parallel with the substrate. US 2003/0140854 A1 discloses an atomic layer epitaxy apparatus comprising a sprayhead that includes the reactant and the protective gas infeed channels, attached to the top of the reaction chamber. In US 2010/0166955 A1, gas is delivered to the reaction chamber through an input plenum which allows gas volume increase to reduce gas flow velocity and gas pressure prior to the gas reaching the reaction chamber so that gas flow into the reaction chamber is less turbulent.

### BRIEF SUMMARY

The present invention is conceived to solve the problems as described above, and aspects of the present invention are to provide a method according to claim 5 and system according to claim 1 for thin film deposition, which includes a process chamber configured to provide a laminar gas flow and virtually divided into several spaces when a reaction gas and a purge gas are consecutively supplied into the process chamber, so that atomic layer deposition can be performed with respect to a plurality of substrates while the virtually divided spaces are moved within the process chamber, thereby reducing process tack time.

In accordance with one aspect of the invention, a thin film deposition system includes an external chamber having an opening at one side thereof; a process chamber disposed inside the external chamber and having an opening at one side thereof; a first door opening or closing the opening of the process chamber; a cassette holder connected to an inner wall of the first door and loading at least one cassette thereon; a second door opening or closing the opening of the external chamber; a connecting member connecting the first door to the second door; and a shifting unit horizontally reciprocating the first door and the cassette holder together with the second door.

In accordance with another aspect of the invention, a thin film deposition system may include a cassette loading a plurality of substrates such that the substrates are separated constant distances from each other and the distance between the respective substrates becomes a distance between laminar flows; a process chamber which receives the cassette such that a distance between the cassette and an inner wall of the process chamber becomes the distance between laminar flows, and in which the substrates are subjected to atomic layer deposition; a gas supply unit disposed at one sidewall of the process chamber and supplying gas to all of the substrates placed in the cassette in a direction parallel to arrangement of the substrates such that a laminar flow of the gas is provided to leading ends of the substrates, to a space between the substrates, and to a space between the substrate and the wall of the process chamber; and a gas exhaust unit disposed at an opposite side with respect to the gas supply unit in the process chamber and discharging the gas from the process chamber by suctioning the gas at rear sides of the substrates.

### BRIEF DESCRIPTION OF THE DRAWINGS

The above and other aspects, features and advantages of the invention will become apparent from the following description of embodiments given in conjunction with the accompanying drawings, in which:
Fig. 1 is a perspective view of a thin film deposition system according to one embodiment of the present invention;
Fig. 2 is a sectional view of the thin film deposition system according to the exemplary embodiment of the present invention;
Fig. 3 is a sectional view of a connecting member of the thin film deposition system according to the embodiment of the present invention;
Fig. 4 is a sectional view of a cassette loaded in a process chamber of the thin film deposition system according to the embodiment of the present invention;
Fig. 5 is a sectional view of the thin film deposition system according to the embodiment of the present invention;
Fig. 6 is a sectional view of the thin film deposition system according to the embodiment of the present invention; and
Figs. 7 and 8 are views of the process chamber of the thin film deposition system according to the embodiment of the present invention.

### DETAILED DESCRIPTION OF THE EMBODIMENTS

Exemplary embodiments of the present invention will now be described in detail with reference to the accompanying drawings.

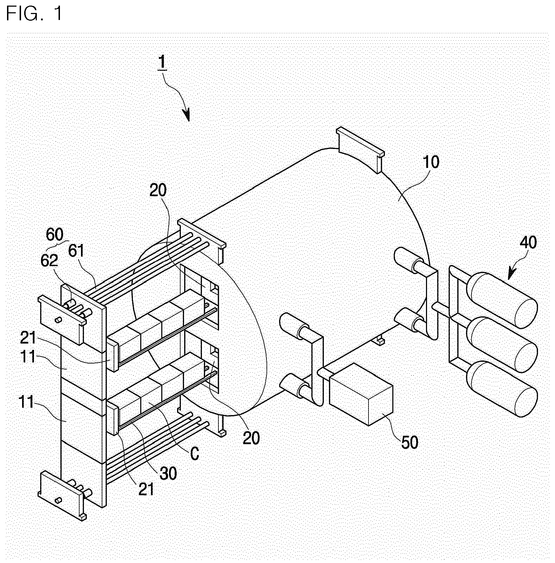

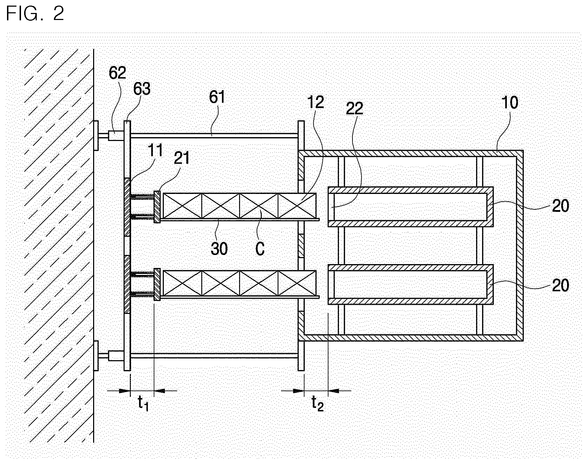

Referring to Figs. 1 and 2, a thin film deposition system 1 according to one embodiment of the invention includes an external chamber 10, a process chamber 20, doors 11, 21, a cassette holder 30, a connecting member 70, and a shifting unit 60.

The external chamber 10 is formed at one side thereof with an opening 12, through which cassettes C are transferred. The external chamber 10 receives a plurality of process chambers 20.

Each of the process chambers 20 receives cassettes C, on which substrates are loaded, such that atomic layer deposition is performed on the substrates therein, as described in detail below.

The process chamber is formed with an opening 22, and includes a first door 21 to open or close the opening and a second door 11 to open or close the opening 12 of the external chamber. The first door 21 is connected to the second door 11 by a connecting member 70. Next, this configuration will be described in more detail. Here, the distance (t1) between the first door 21 and the second door 11 is greater than the distance (t2) between the opening 12 of the external chamber and the opening 22 of process chamber (t1>t2).

In addition, the first door 21 is provided at an inner wall thereof with a cassette holder 30 capable of loading a plurality of cassettes C.

As such, the second door 11, the first door 21 and the cassette holder 30 are fixedly connected to one another, and the process chamber further includes a shifting unit 60 which reciprocates the first and second doors and the cassette holder in a horizontal direction at the same time.

The shifting unit 60 includes a screw 61 such as a typical ball-screw member, a nut member 62 reciprocating upon rotation of the screw 61, a jig 63 connecting the nut member 62 to the second door 11, and a drive source (not shown) for rotating the screw 61.

The system further includes a gas supply unit 40, which supplies a source gas and a purge gas into the process chambers 20 through the external chamber 10, and an exhaust unit 50 which exhausts gas from the process chambers 20.

Although not shown in the drawings, the system may further include a heater between the external chamber 10 and the process chambers 20. The heater maintains the process chambers 20 at constant temperature.

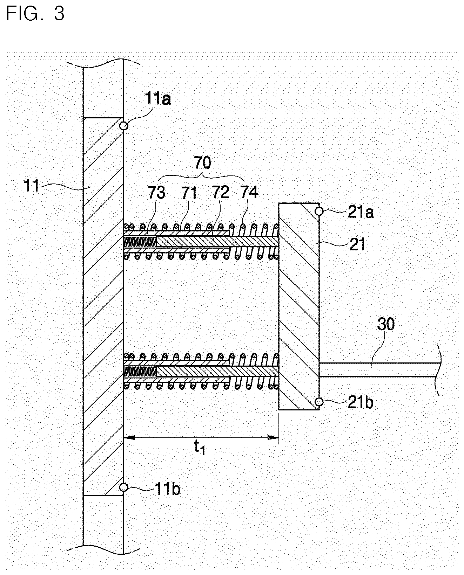

Main components of the thin film deposition system according to this embodiment will be described in more detail with reference to Fig. 3. Referring to Fig. 3, the connecting member 70 connecting the first door 21 to the second door 11 is made of an elastically stretchable pogo pin member. Specifically, the connecting member 70 includes a large diameter section 71 secured to the second door 11, a small diameter section 72 secured to the first door 21, and a compressive spring 73 which elastically supports the small diameter section 72 within the large diameter section 71. Further, the connecting member 70 realized by the pogo pin member is further provided at an outer periphery thereof with another compressive spring 74 which has a higher coefficient of elasticity than the compressive spring 73. Thus, the distance between the first door 21 and the second door 11 may be changed instead of being fixed, so that the first door 21 and the second door 11 may approach each other or may move apart from each other.

Further, each of the first and second doors 21, 11 is provided with a sealing member 11a or 21b, which may be realized by a mechanical seal, an O-ring, or other sealing members known in the art. For example, the sealing member 21a of the first door 21 is a mechanical seal and the sealing member 11a of the second door is an O-ring.

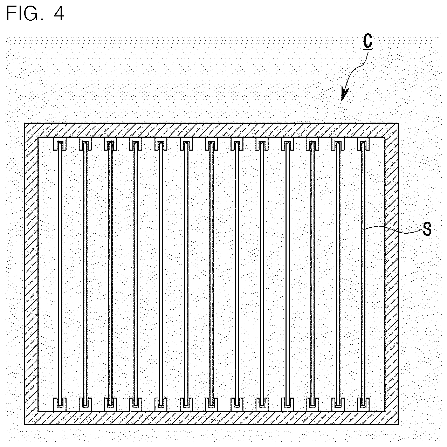

Fig. 4 shows a cassette C loaded in the process chamber 20. Referring to Fig. 4, a plurality of substrates is loaded in a standing posture (in a vertical direction or inclined at a certain angle with respect to the vertical direction) in the cassette C.

Next, operation of the thin film deposition system will be described with reference to Figs. 2, 5 and 6.

First, with the first and second doors 21, 11 open, a plurality of cassettes C receiving substrates is mounted on the cassette holder 30 connected to one side of the first door 21 (see Fig. 2).

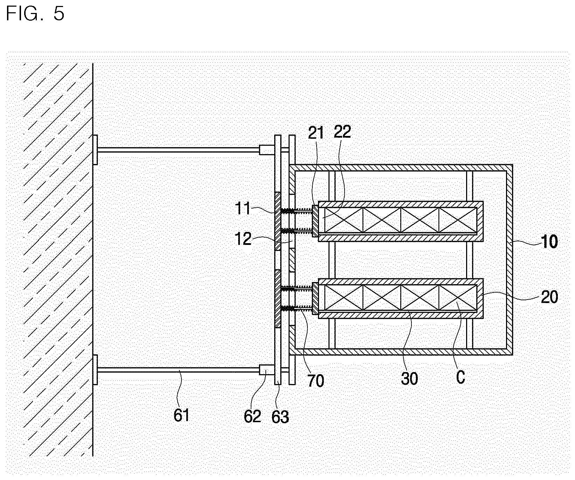

Next, when the screw 61 is rotated by primarily driving the drive source, the nut member 62 linearly moves to allow the first and second door 21, 11 connected to each other to move, so that the first door 21 closes the opening 22 of the process chamber. At the same time, the cassette holder 30 enters the process chamber 20, so that the cassettes C are transferred into the process chamber 20 by the cassette holder. In this stage, the second door 11 does not contact a sidewall of the external chamber 10 (see Fig. 5).

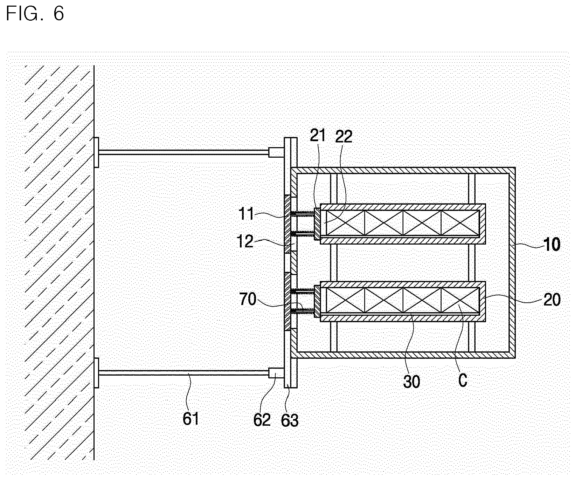

Next, when the screw 61 is rotated by secondarily driving the drive source, the second door 11 linearly moves by the same method as described above, so that the second door 11 closes the opening 12 of the external chamber 10. However, the first door 21 and the cassette holder 30 are in the same state as that shown in Fig. 6, and the connecting member 70 connecting the first door 21 to the second door 11 is contracted as the compressive springs 73, 74 are contracted (see Fig. 6).

As such, with the cassettes C transferred into the process chamber 20 and the external chamber 10 and the process chamber 20 closed, source gas and purge gas are alternately supplied into the process chamber to perform atomic layer deposition with respect to the substrates.

Thus, in this embodiment, transfer of the cassettes (or substrates) and closing of the external chamber and the process chamber are performed at the same time.

Obviously, the above description of the embodiment is provided for illustration only and various modifications and changes can be made without departing from the present invention. For example, the distance between the first door and the second door may be smaller than the distance between the opening of the process chamber and the opening of the external chamber. In this case, the second door is moved to close the opening of the external chamber through primary driving of the drive source, and the first door is then moved to close the process chamber through secondary driving of the drive source.

In another embodiment, the thin film deposition system may eliminate the external chamber. In this case, the second door for opening or closing the external chamber and the connecting member for connecting the second door to the first door are also eliminated, and the shifting unit may be directly connected to the first door. In this embodiment, the cassette holder is connected to the inner wall of the first door. Thus, the cassettes may be transferred into the process chamber when the first door closes the process chamber. Thus, in this embodiment, transfer of the cassettes (or substrates) and closing of the process chamber are also performed at the same time.

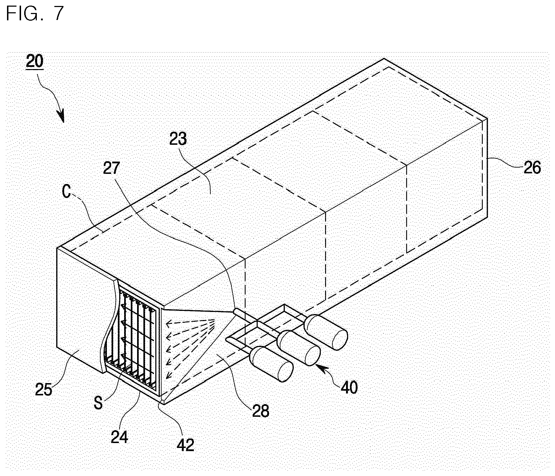

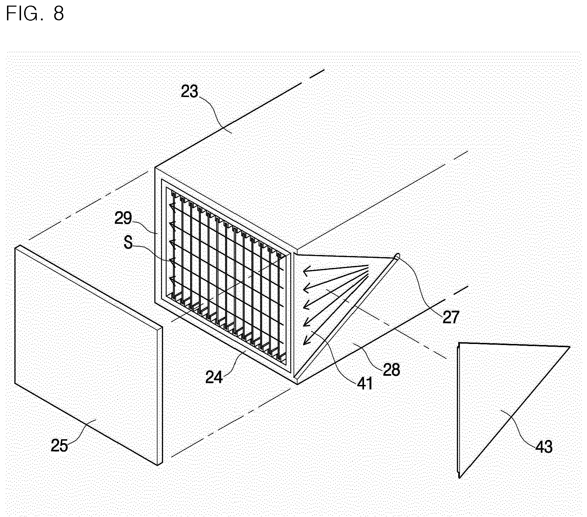

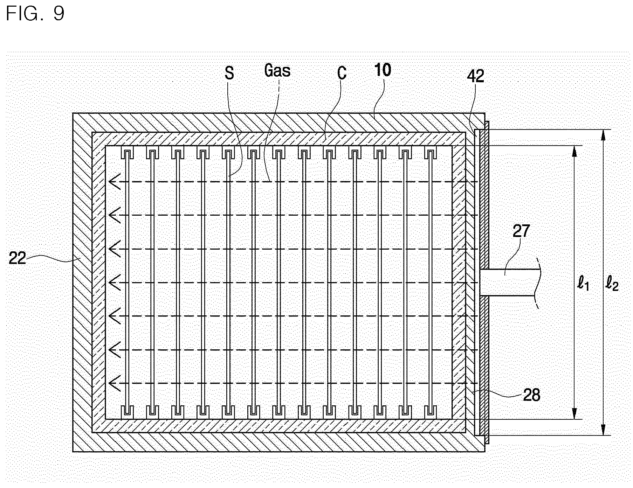

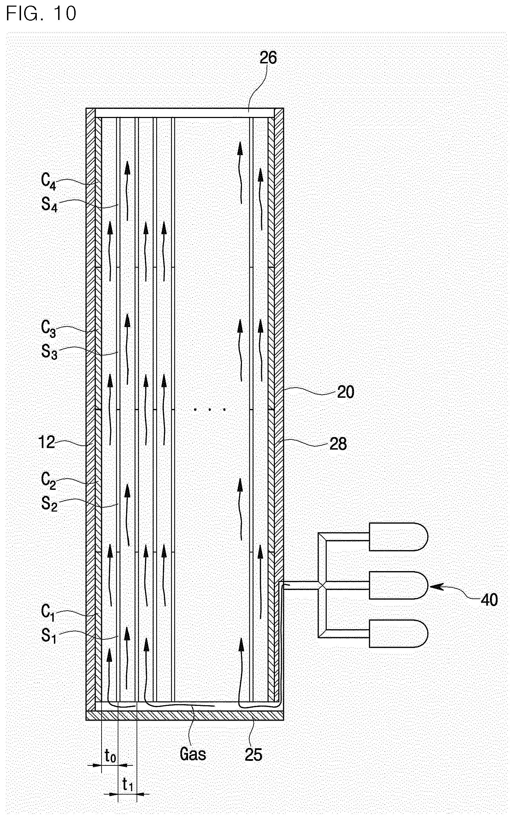

Next, referring to Figs. 7 and 8, the process chamber 20 according to the embodiment will be described in more detail. Within the process chamber 20, a plurality of cassettes C each receiving substrates S arranged in a standing posture (in a vertical direction or inclined at a certain angle to the vertical direction) is transferred in an in-line arrangement so as to allow simultaneous processing of the plurality of substrates.

In other words, plural rows of substrates are disposed in an in-line arrangement within the process chamber. Further, respective spaces between the rows of substrates provide gas flow passages.

Specifically, in this embodiment, when the cassettes C are placed in the process chamber 20, the cassettes C are disposed such that the distance between each cassette and the sidewall of the process chamber or the distance between the respective substrates received in each of the cassettes C becomes a distance between laminar flows.

As used herein, the term "laminar flow" refers to a flow of gas supplied into a narrow space and moving in a certain direction without free diffusion and substantially no scattering.

Further, as used herein, the term "distance between laminar flows" refers to a distance between two laminar flows of gas. In this embodiment, the distance between laminar flows is 0.2 to 10 mm. If the distance between laminar flows is less than 0.2 mm, the system has difficulty not only in processing and manufacture, but also in control of gas supply. If the distance between laminar flows exceeds 10 mm, the laminar flow of gas is not maintained, causing free diffusion of the gas.

According to this embodiment, not only the space between the substrates S within each of the cassettes C, but also the space between each cassette C and each wall of the chamber and the space between the leading ends of the cassettes C or substrates S and a straight gas supply groove are set corresponding to the distance between laminar flows.

A gas diffusion supply section 42 is formed on one sidewall 28 of the process chamber 20 to transfer gas to a leading end of the sidewall along the sidewall when supplied through a gas supply port 27.

The gas diffusion supply section 42 includes a recess 41 formed like a step on an outer surface of the one sidewall 28 of the process chamber, and a lid 43 closing the recess 41. Of course, although the recess 41 is covered with the lid 43, the lid 43 is separated from a bottom surface of the recess 41 to define a space for gas flow between the recess 41 and the lid 43.

The gas diffusion supply section 42 may be formed on any sidewall of the process chamber 20 such as an upper, lower, right or left sidewall 23, 24, 28 or 29.

The gas diffusion supply section 42 is formed to have a cross-sectional area gradually increasing from the gas supply port 27 on the sidewall 28 towards the leading end thereof. This configuration allows uniform distribution of gas before the gas reaches the front side of the process chamber 20 through the gas diffusion supply section 42. Further, while passing through the gas diffusion supply section 42, the gas supplied through the gas supply port 27 maintains a laminar flow. Thus, the distance between the gas diffusion supply section 42 and the lid 43 is set to maintain a laminar gas flow.

Next, operation of the process chamber according to this embodiment will be described.

First, when gas is supplied to the gas supply port 27 formed on one sidewall of the process chamber 20 from a gas supply unit, the gas flows to the front side of the process chamber (that is, to the leading end of the sidewall) along the gas diffusion supply section 42 while being uniformly diffused by the gas diffusion supply section 42.

Then, the gas sufficiently diffused along the gas diffusion supply section 42 moves as a laminar gas flow towards an opposite sidewall along a straight gas supply groove formed on the front side of the process chamber 20.

After reaching front sides of the substrates, that is, the straight gas supply groove, the gas forms a thin film on each of the substrates while moving as a laminar flow through spaces between the respective rows of substrates.

Accordingly, the space between the respective rows of substrates constitutes a flow passage which maintains the distance between laminar flows so as to allow gas to move as a laminar flow within the process chamber. Further, within the process chamber, the plurality of cassettes C1 to C4 is disposed adjacent each other in an in-line arrangement, and substrates S1 to S4 received in adjacent cassettes are also arranged adjacent each other, so that the gas uniformly flows in the plurality of cassettes while maintaining a laminar flow.

In this embodiment, instead of performing operation of pumping or purging the first reaction gas from the process chamber after stopping supply of a first reaction gas, a purge gas is supplied immediately after the first reaction gas into the process chamber, so that the first reaction gas and the purge gas coexist within the single vacuum chamber while virtually dividing the internal space of the vacuum chamber.

In this embodiment, a first reaction gas space refers to an imaginary space of the process chamber filled with the first reaction gas, and a first purge gas space refers to an imaginary space of the process chamber filled with the purge gas and consecutive to the first reaction gas space. Further, a second reaction gas refers to an imaginary space of the process chamber filled with a second reaction gas, and a second purge gas space refers to an imaginary space of the process chamber filled with the purge gas and consecutive to the second reaction gas. According to this embodiment, the first reaction gas space, the first purge gas space, the second reaction gas space, and the second purge gas space move at a predetermined rate in a predetermined direction at the same time instead of remaining at certain places.

Specifically, a process of forming the gas spaces will be described hereinafter. First, when the first reaction gas is supplied to the process chamber, the imaginary first reaction gas space filled with the first reaction gas is created within the vacuum chamber and moves from one space to the other space within the process chamber.

Then, when a purge gas is supplied after stopping supply of the first reaction gas, the first purge gas space consecutive to the first reaction gas space is created within the vacuum chamber and follows the first reaction gas space while pushing the first reaction gas in the moving direction thereof. Here, an interface between the first reaction gas space and the first purge gas space is not clearly formed, and a mixed section between the first reaction gas and the purge gas may be present at the interface. Further, the concentration of the first reaction gas gradually increases towards the center of the first reaction gas space, and the concentration of the purge gas gradually increases towards the center of the first purge gas space.

As described above, according to this embodiment, in order to achieve complete purging of the first reaction gas from the process chamber, the purge gas forming the first purge gas space is supplied in a much greater amount than the first reaction gas, such that the first reaction gas is moved in an opposite direction relative to the straight gas supply groove by movement of the first purge gas.

Then, the second reaction gas space is formed consecutive to the first purge gas space by supplying a second reaction gas. Further, the second purge gas space is formed consecutive to the second reaction gas space by supplying a large amount of purge gas, so that the second reaction gas may be completely removed by movement of the second purge gas space.

As such, according to this embodiment, atomic layer deposition is carried out while the first reaction gas space, the first purge gas space, the second reaction gas space and the second purge gas space sequentially move within the process chamber. Thus, according to this embodiment, reaction gas supply and purging are consecutively performed like a process of scanning substrates within a single process chamber, thereby significantly reducing process time while substantially increasing throughput, as compared with a conventional process in which reaction gas supply and purging are intermittently performed with respect to the overall inner space of the process chamber.

Further, the above process may be repeatedly performed through a plurality of cycles as needed. It should be understood that exhaust operation is carried out during supply of the respective gases.

As described above, according to the embodiment, the thin film deposition system includes a process chamber and cassettes arranged to form a laminar gas flow in the process chamber virtually divided into several spaces when a reaction gas and a purge gas are subsequently supplied into the process chamber, such that atomic layer deposition is sequentially performed on a plurality of substrates loaded within the process chamber while the virtually divided spaces are moved in a scanning manner within the process chamber, thereby reducing a process tack time.

Namely, the thin film deposition system according to the embodiment allows atomic layer deposition to be consecutively performed while a reaction gas and a purge gas are sequentially supplied into the single process chamber instead of performing separate pumping or purging operation with respect to each of reaction gases in the process chamber.

In addition, in the deposition system according to the embodiment, substrates are arranged in plural rows in order to supply gas to a space between the substrate, thereby enabling formation of a uniform thin film.

Further, in the deposition system according to the embodiment, doors for opening or closing the process chamber are integrally formed with a cassette holder, so that cassettes can be loaded or unloaded simultaneously with opening or closing of the process chamber.

Although some embodiments have been described herein, it will be apparent to those skilled in the art that the embodiments are given by way of illustration and that various modifications, additions, changes and variations can be made without departing from the scope of the invention. Accordingly, the scope of the invention should be limited only by the accompanying claims.

## Claims

1. A thin film deposition system comprising:
a cassette loading a plurality of substrates such that the substrates are separated constant distances from each other and the distance between the respective substrates is between 0.2 and 10 mm;
a process chamber which receives the cassette such that a distance between the cassette and an inner wall of the process chamber is the distance between 0.2 and 10 mm, and in which the substrates are subjected to atomic layer deposition;
a gas supply unit disposed at one sidewall of the process chamber and supplying gas to all of the substrates placed in the cassette in a direction parallel to arrangement of the substrates such that a laminar flow of the gas is provided to leading ends of the substrates, to a space between the substrates, and to a space between the substrate and the wall of the process chamber; and
a gas exhaust unit disposed at an opposite side to the gas supply unit in the process chamber and exhausting the gas from the process chamber by suctioning the gas at rear sides of the substrates.

2. The system of claim 1, wherein the gas supply unit comprises a straight gas supply groove formed on the sidewall of the process chamber having the gas supply unit disposed thereon and allows gas to flow from one side of the sidewall to a region including other side thereof in a laminar flow manner through the straight gas supply groove.

3. The system of claim 2, wherein the gas supply unit comprises:
a gas diffusion supply section formed on a sidewall of the process chamber adjacent to the sidewall having the gas supply unit disposed thereon and supplying gas to the straight gas supply groove through uniform diffusion of the gas over the entirety of one side of the sidewall; and
a gas supply port provided to one end of the gas diffusion supply section and supplying the gas to the gas diffusion supply section therethrough.

4. The system of claim 1, wherein the distance between the respective substrates and between the cassette and an inner wall of the process chamber is between 0.5 and 10 mm.

5. A thin film deposition method comprising:
1) placing a cassette loading a plurality of substrates within a process chamber such that a distance between the substrates and a distance between the cassette and the process chamber is between 0.2 and 10 mm, followed by exhausting gas from the process chamber;
2) supplying a first reaction gas into the process chamber such that a first reaction gas space occupied by the first reaction gas sequentially moves from one space to the other space within the process chamber;
3) supplying a purge gas into the process chamber simultaneously with blocking of the first reaction gas, such that a first purge gas space is formed consecutive to the first reaction gas space and moves in the same direction as that of the first reaction gas space;
4) supplying a second reaction gas into the process chamber simultaneously with blocking of the purge gas, such that a second reaction space is formed consecutive to the first purge gas space and moves in the same direction as that of the first purge gas space; and
5) supplying the purge gas into the process chamber simultaneously with blocking of the second reaction gas, such that a second purge gas space is formed consecutive to the second reaction gas space and moves in the same direction as that of the second reaction gas space,
wherein an exhaust operation is performed without stopping during operations 1) to 5) in an opposite direction to a direction of supplying the reaction gases and purge gas by suctioning and exhausting the gases from the process chamber.

6. The method of claim 5, wherein a cycle of performing the operations 1) to 5) is repeatedly performed.

7. The method according to any of cliams 5 and 6, wherein the distance between the substrates and the distance between the cassette and the process chamber is between 0.5 and 10 nm.

## Patentansprüche

1. Dünnfilmablagerungssystem mit:
einer Kassette, die eine Vielzahl von Substraten lädt, so dass die Substrate in festen Abständen voneinander getrennt sind und der Abstand zwischen den betreffenden Substraten zwischen 0,2 und 10 mm beträgt;
einer Prozesskammer, die die Kassette aufnimmt, so dass ein Abstand zwischen der Kassette und einer Innenwand der Prozesskammer zwischen 0,2 und 10 mm beträgt, und wobei die Substrate einer Atomlagenabscheidung unterzogen werden;
einer Gaszufuhreinheit, die an einer Seitenwand der Prozesskammer angeordnet ist und Gas an alle Substrate liefert, die in der Kassette platziert sind, in einer Richtung parallel zur Anordnung der Substrate, so dass ein laminare Strömung des Gases zu den Anfangsenden der Substrate, zu einem Raum zwischen den Substraten und zu einem Raum zwischen dem Substrat und der Wand der Prozesskammer entsteht; und
einer Gasauslasseinheit an einer der Gaszufuhreinheit gegenüberliegenden Seite in der Prozesskammer, die das Gas aus der Prozesskammer durch Absaugung an den Rückseiten der Substrate ablässt.

2. System nach Anspruch 1, wobei die Gaszufuhreinheit eine gerade Gaszufuhrnut umfasst, die an der Seitenwand der Prozesskammer mit der Gaszufuhreinheit darauf gebildet ist, so dass Gas von einer Seite der Seitenwand zu einem Bereich strömen kann, der deren andere Seite einschließt, auf einer laminare Strömungsart, durch die gerade Gaszufuhrnut.

3. System nach Anspruch 2, wobei die Gaszufuhreinheit folgendes umfasst:
einen Gasdiffusionszufuhr-Abschnitt auf einer Seitenwand der Prozesskammer angrenzend an die Seitenwand, an der die Gaszufuhreinheit angeordnet ist, der Gas an die gerade Gaszufuhrnut liefert, durch gleichmäßige Diffusion des Gases über die Gesamtheit einer Seite der Seitenwand; und
eine Gaszufuhröffnung an einem Ende des Gasdiffusionszufuhr-Abschnitts, die das Gas dadurch an den Gasdiffusionszufuhr-Abschnitt liefert.

4. System nach Anspruch 1, wobei der Abstand zwischen den betreffenden Substraten und zwischen der Kassette und einer Innenwand der Prozesskammer zwischen 0,5 und 10 mm beträgt.

5. Verfahren zur Dünnfilmablagerung mit:
1) Platzieren einer Kassette, die eine Vielzahl von Substraten innerhalb einer Prozesskammer lädt, so dass ein Abstand zwischen den Substraten und ein Abstand zwischen der Kassette und der Prozesskammer zwischen 0,2 und 10 mm beträgt, gefolgt vom Ablassen von Gas aus der Prozesskammer;
2) Liefern eines ersten Reaktionsgases in die Prozesskammer, so dass ein erster Reaktionsgasraum, der von dem ersten Reaktionsgas eingenommen wird, sich sequentiell von einem Raum zu dem anderen Raum innerhalb der Prozesskammer bewegt;
3) Liefern eines Spülgases in die Prozesskammer, mit gleichzeitiger Blockierung der ersten Reaktionsgases, so dass ein erster Spülgasraum gebildet wird, der auf den ersten Reaktionsgasraum folgt, und sich in dieselbe Richtung bewegt wie der des ersten Reaktionsgasraumes;
4) Liefern eines zweiten Reaktionsgases in die Prozesskammer mit gleichzeitiger Blockierung des Spülgases, so dass ein zweiter Reaktionsraum gebildet wird, der auf den ersten Spülgasraum folgt und sich in dieselbe Richtung bewegt wie der des ersten Spülgasraumes; und
5) Liefern des Spülgases in die Prozesskammer mit gleichzeitiger Blockierung des zweiten Reaktionsgases, so dass ein zweiter Spülgasraum gebildet wird, der auf den zweiten Reaktionsgasraum folgt und sich in dieselbe Richtung bewegt wie der des zweiten Reaktionsgasraumes,
wobei eine Auslassoperation durchgeführt wird, ohne Unterbrechung während der Phasen 1) bis 5) in einer Gegenrichtung zu einer Richtung des Lieferns der Reaktionsgase und des Spülgases, durch Absaugen und Ablassen der Gase aus der Prozesskammer.

6. Verfahren nach Anspruch 5, wobei ein Zyklus der Phasen 1) bis 5) wiederholt durchgeführt wird.

7. Verfahren nach einem beliebigen der Ansprüche 5 und 6, wobei der Abstand zwischen den Substraten und der Abstand zwischen der Kassette und der Prozesskammer zwischen 0,5 und 10 nm beträgt.

## Revendications

1. Système de dépôt de couches minces comprenant :
une cassette chargeant une pluralité de substrats de telle sorte que les substrats sont séparés de distances constantes les uns des autres et la distance entre les substrats respectifs est entre 0,2 et 10 mm ;
une chambre de traitement qui reçoit la cassette de telle sorte qu'une distance entre la cassette et une paroi interne de la chambre de traitement est la distance entre 0,2 et 10 mm, et dans laquelle les substrats sont soumis à un dépôt de couche atomique ;
une unité de distribution de gaz disposée à une paroi latérale de la chambre de traitement et distribuant du gaz à tous les substrats placés dans la cassette dans une direction parallèle à l'agencement des substrats de telle sorte qu'un écoulement laminaire du gaz est assuré aux extrémités avant des substrats, à un espace entre les substrats et à un espace entre le substrat et la paroi de la chambre de traitement ; et
une unité d'échappement de gaz disposée à un côté opposé à l'unité de distribution de gaz dans la chambre de traitement et laissant s'échapper le gaz de la chambre de traitement par aspiration du gaz à des côtés arrière des substrats.

2. Système selon la revendication 1, dans lequel l'unité de distribution de gaz comprend une rainure rectiligne de distribution gaz formée sur la paroi latérale de la chambre de traitement ayant l'unité de distribution de gaz disposée sur celle-ci et permet au gaz de s'écouler d'un côté de la paroi latérale à une région comprenant un autre côté de celle-ci en un écoulement laminaire à travers la rainure rectiligne de distribution de gaz.

3. Système selon la revendication 2, dans lequel l'unité de distribution de gaz comprend :
une section de distribution par diffusion de gaz formée sur une paroi latérale de la chambre de traitement adjacente à la paroi latérale ayant l'unité de distribution de gaz disposée sur celle-ci et distribuant du gaz à la rainure rectiligne de distribution de gaz par diffusion uniforme du gaz sur la totalité d'un côté de la paroi latérale ; et
un orifice de distribution de gaz prévu sur une extrémité de la section de distribution par diffusion de gaz et distribuant le gaz à la section de distribution par diffusion de gaz à travers celui-ci.

4. Système selon la revendication 1, dans lequel la distance entre les substrats respectifs et entre la cassette et une paroi interne de la chambre de traitement est entre 0,5 et 10 mm.

5. Procédé de dépôt de couches minces comprenant :
1) placer une cassette chargeant une pluralité de substrats à l'intérieur d'une chambre de traitement de telle sorte qu'une distance entre les substrats et une distance entre la cassette et la chambre de traitement est entre 0,2 et 10 mm, puis évacuer du gaz de la chambre de traitement ;
2) distribuer un premier gaz de réaction dans la chambre de traitement de telle sorte qu'un premier espace de gaz de réaction occupé par le premier gaz de réaction se déplace séquentiellement d'un espace à l'autre espace à l'intérieur de la chambre de traitement ;
3) distribuer un gaz de purge dans la chambre de traitement simultanément avec le blocage du premier gaz de réaction, de telle sorte qu'un premier espace de gaz de purge est formé après le premier espace de gaz de réaction et se déplace dans la même direction que celle du premier espace de gaz de réaction ;
4) distribuer un second gaz de réaction dans la chambre de traitement simultanément avec le blocage du gaz de purge, de telle sorte qu'un second espace de réaction est formé après le premier espace de gaz de purge et se déplace dans la même direction que celle du premier espace de gaz de purge ; et
5) distribuer le gaz de purge dans la chambre de traitement simultanément avec le blocage du second gaz de réaction, de telle sorte qu'un second espace de gaz de purge est formé après le second espace de gaz de réaction et se déplace dans la même direction que celle du second espace de gaz de réaction,
une opération d'échappement étant réalisée sans arrêt pendant les opérations 1) à 5) dans une direction opposée à une direction de distribution des gaz de réaction et du gaz de purge par aspiration et échappement des gaz à partir de la chambre de traitement.

6. Procédé selon la revendication 5, dans lequel un cycle pour réaliser les opérations 1) à 5) est réalisé de manière répétée.

7. Procédé selon l'une quelconque des revendications 5 et 6, dans lequel la distance entre les substrats et la distance entre la cassette et la chambre de traitement est entre 0,5 et 10 nm.
